**Europäisches Patentamt**

**European Patent Office**

**Office européen des brevets**

(19)

(11) Veröffentlichungsnummer : **0 259 256 B1**

(12) **EUROPÄISCHE PATENTSCHRIFT**

(45) Veröffentlichungstag der Patentschrift :
13.03.91 Patentblatt 91/11

(51) Int. Cl.$^5$ : **H03K 3/30**

(21) Anmeldenummer : **87810471.0**

(22) Anmeldetag : **24.08.87**

(54) **Astabiler, magnetisch gekoppelter Multivibrator.**

(30) Priorität : **05.09.86 CH 3574/86**

(43) Veröffentlichungstag der Anmeldung :
**09.03.88 Patentblatt 88/10**

(45) Bekanntmachung des Hinweises auf die
Patenterteilung :
**13.03.91 Patentblatt 91/11**

(84) Benannte Vertragsstaaten :
**AT CH DE ES FR GB IT LI NL SE**

(56) Entgegenhaltungen :
**WO-A-87/01505**
**US-A- 3 305 759**
**US-A- 4 164 014**

(56) Entgegenhaltungen :
**US-A- 4 553 070**
**HEWLETT-PACKARD JOURNAL, August 1981,
Seiten 3-10, California, US; R. MYERS et al.:
"200-kHz power FET Technology in new modular power supplies"**

(73) Patentinhaber : **Ascom Hasler AG**
**Belpstrasse 23**
**CH-3000 Bern 14 (CH)**

(72) Erfinder : **Kislovski, André**
**Wylerringstrasse 1**
**CH-3014 Bern (CH)**

(74) Vertreter : **Schwerdtel, Eberhard, Dr.**
**Ascom Tech AG Abteilung KTMR Belpstrasse
23 Postfach**
**CH-3000 Bern 14 (CH)**

## Beschreibung

Die Erfindung betrifft einen astabilen, magnetisch gekoppelten Multivibrator entsprechend dem Oberbegriff von Anspruch 1.

Aus R. Myers und R.D. Peck, 200-kHz Power FET Technology in New Modular Power Supplies, HEWLETT-PACKARD Journal (August 1981), Seiten 3 bis 7 plus 10, ist eine Serie 6500 A von acht Speisegerät-Modellen bekannt. Diese Modelle geben eine Leistung von 50 W Gleichstrom bei 5, 12, 15 und 18 V Ausgangsspannung ab. Im elektrischen Aufbau handelt es sich um schaltgeregelte Leistungswandler, die im Rückkoppelkreis einen Multivibrator aufweisen, dessen Frequenz geregelt ist. Dieser Multivibrator weist zwei im Gegentakt scharf geschaltete MOSFET-Transistoren auf, zwei Festkondensatoren, einen Transformator und einen Basiswiderstand.

Die Frequenz wird geregelt über die variable Induktivität L eines elektrisch steuerbaren Induktors. Diese ist eine Regeldrossel mit zwei E-förmigen Kernen, die nach der Methode der Sättigungssteuerung betrieben wird. Hierbei ist die Steuerwicklung auf dem Mittelsteg und die Induktionswicklung in Form zweier in Reihe geschalteter Einzelwicklungen auf den beiden Aussenstegen der Kerne angeordnet. Das Kernmaterial besitzt sehr hohe Permeabilität und die Flussdichten in den beiden Aussenstegen werden auf Grund geringen Steuerstromes stets im Gleichgewicht gehalten. (W. Seipel, Magnetic Components for High-Frequency Switching Power Supplies, HEWLETT-PACKARD Journal (August 1981), Seiten 8 und 9).

Bei der Konstruktion des beschriebenen Induktors hat man sich bemüht, die grundsätzlichen, nachteiligen Eigenschaften von Regeldrosseln mit Sättigungssteuerung (bzw. Strombegrenzungssteuerung bzw. Sättigungswinkelsteuerung) (bekannt z.B. aus H. Krakowski, Die magnetische Regeltechnik und ihre Anwendung in den Stromversorgungsanlagen der Deutschen Bundespost, Der Fernmeldeingenieur 8. Jahrgang/Heft 7 (15. Juli 1954), Seiten 1 ff) zu minimieren. Dies ist sicherlich teilweise gelungen. Trotzdem ist dieser Induktor das kritischte Element in den Speisegeräten der Serie 65000A geblieben.

Es ist daher die Aufgabe der vorliegenden Erfindung, für entsprechende Speisegeräte eine neue, grundsätzlich bessere Art von elektrisch steuerbaren Induktoren anzugeben.

Diese Aufgabe wird gelöst durch den Einsatz eines induktiven Bauelements, wie es im kennzeichnenden Teil von Anspruch 1 definiert und in der Schrift WO-A-8701505 beschrieben ist. Diese Schrift wurde am 12.03.87, d.h. nach dem Anmeldetag der Anmeldung veröffentlieht, und fällt unter Artikel 54 (3) und (4) EPÜ, mit Ausnahme von Sapnien. Die anderen Ansprüche geben Ausgestaltungen der Erfindung an.

Im folgenden wird die Erfindung anhand von drei Figuren beispielsweise eingehend beschrieben. Es zeigen :

Fig. 1 – Schaltbild eines astabilen, magnetisch gekoppelten Multivibrators

Fig. 2 – Aufbau eines elektrisch steuerbaren, induktiven Bauelements

Fig. 3 – Symbolische Darstellung des Bauelements.

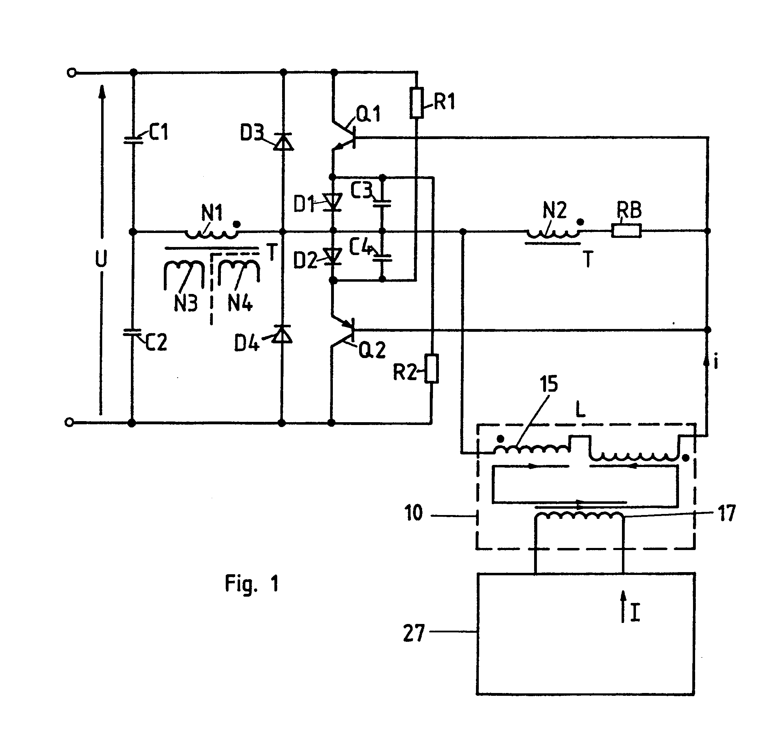

Fig. 1 zeigt das Schaltbild eines astabilen, magnetisch gekoppelten Multivibrators. Dieser weist im Leistungsteil zwei Kondensatoren C1 und C2 mit gleicher, konstanter Kapazität auf sowie die Primärwicklung N1 eines Aus- und Rückkoppeltransformators T. Über den beiden Kondensatoren C1 und C2 liegt die Eingangsspannung U. Als aktive Schaltelemente dienen zwei Schalttransistoren Q1 (npn-Typ) und Q2 (pnp-Typ), die mit zwei Dioden D1, D2 in Reihe geschaltet sind, und deren Funktion durch zwei weitere Dioden D3, D4 ergänzt wird.

Die positive Rückkopplung des Multivibrators erfolgt über die Wicklung N2 des Transformators T. Dieser Wicklung N2 nachgeschaltet ist ein ohmscher Basiswiderstand RB, der mit seinem einen Pol an die Basis beider Transistoren Q1 und Q2 angeschlossen ist. Parallel zur Wicklung N2 und dem Basiswiderstand RB ist ein elektrisch steuerbares, induktives Bauelement 10 angeschlossen, das über eine Steuerschaltung 27 mittels eines Stromes I angesteuert wird.

Die Schaltung wird noch ergänzt durch je zwei Widerstände R1, R2 und Kondensatoren C3, C4 zum Starten der Schwingung. Die Auskopplung der abgebbaren Leistung des Multivibrators erfolgt über eine oder zwei weitere Transformatorwicklungen N3, N4.

Dieser im wesentliche bekannte Multivibrator schwingt mit einer Frequenz, die durch die in der Wicklung N2 induzierte Spannung und durch die hierdurch durch den Basiswiderstand RB und durch die Induktionswicklung 15 des Bauelementes 10 fliessenden Ströme bestimmt wird. Der Strom i durch die Induktionswicklung 15 steigt aufgrund der variierbaren Induktivität L des Bauelements 10 jeweils einstellbar mehr oder weniger schnell an und benötigt damit jeweils eine kontrollierbare Zeit, bis er so gross ist, dass der jeweils leitende Transistor Q1 bzw. Q2 sperrt und der jeweils nichtleitende Transistor Q2 bzw. Q1 leitend wird, d.h. bis die Schaltung kippt. Durch Variation der Induktivität L des Bauelements 10 kann daher die Frequenz geändert, gesteuert bzw. geregelt werden. Hierbei ist es vorteilhaft, wenn die Induktivität L in weiten Grenzen, z.B. im Verhältnis 1 : 100 veränderbar ist und jeweils so wirkt wie eine konventionelle Drosselspule mit jeweils gleichem Induktivitätswert, d.h. wenn sie linear wirkt.

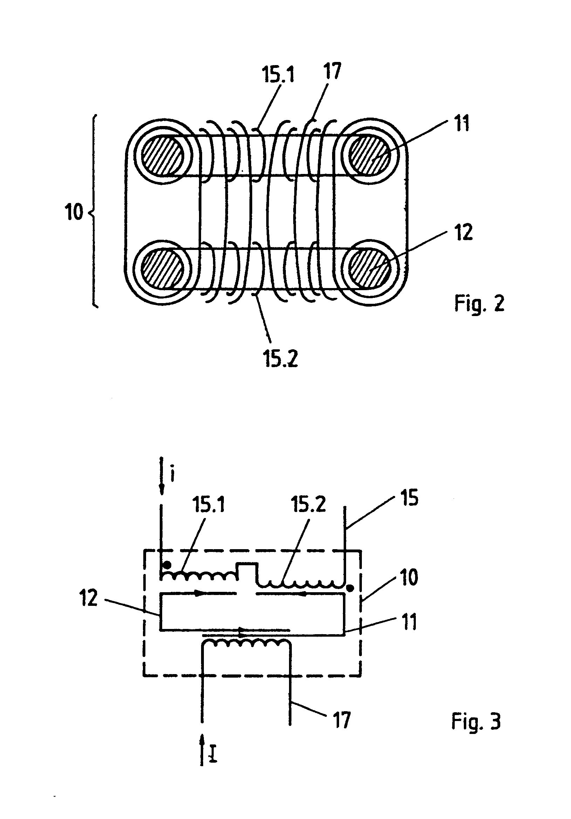

Im folgenden wird ein neues Bauelement 10 beschrieben, das diese Eigenschaften aufweist. Fig. 2 zeigt seinen Aufbau, Fig. 3 seine symbolische Darstellung. Es besteht aus zwei gleichen, ferromagnetischen, hochfrequenztauglichen, koaxial angeordneten, zylindrischen oder besser toroidalen Ringkernen 11, 12, insbesondere Ferritkernen (in Fig. 3 geschnitten dargestellt), von denen jeder im wesentlichen über seinen gesamten Winkelbereich gleichmässig mit einer Teilwicklung 15.1 bzw. 15.2 gleicher Windungszahl umwickelt ist. Diese Teilwicklungen haben entgegengesetzten Wicklungssinn und bilden in Reihe geschaltet eine Induktionswicklung 15, die vom zu beeinflussenden Strom i durchflossen wird. Hierzu kommt eine Steuerwicklung 17, die in einem zweiten Arbeitsgang gemeinsam über die koaxial zusammengefassen Kerne 11, 12 und deren Teilwicklungen 15.1, 15.2 gewickelt ist, ebenfalls gleichmässig über den gesamten Winkelbereich, wodurch sie im Nebeneffekt die Kerne 11 und 12 mechanisch zusammenhält. Die Steuerwicklung 17 wird vom erwähnten Steuerstrom I durchflossen, wobei sich durch die jeweils zugeordnete, gleiche Vormagnetisierung der Ringkerne 11 und 12 für die Induktionswicklung 15 jeweils ein eindeutig zugeordneter Induktivitätswert L einstellt. Aufgrund der beschriebenen Geometrie des induktiven Bauelements 10 ist diese Induktivität für zeitlich wechselnde Ströme mit nicht zu hoher zugeordneter Spannung konstant, verhält sich also stets wie eine der genannten konventionellen Drosselspulen mit jeweils entsprechendem Induktivitätswert L.

Die physikalische Ursache für das genannte Verhalten des neuen Bauelements 10 ist in der genannten Schrift WO-A-8701505 eingehend beschrieben. Es erfolgt daher hier ausdrücklich der Hinweis auf diese Schrift an Stelle einer langen Wiederholung des Inhaltes dieser Schrift. Es sei jedoch erwähnt, dass die funktionale Abhängigkeit der magnetischen Flussdichte B von der magnetischen Feldstärke H beim Kernmaterial einen Verlauf aufweist, der in seinem gesamten Bereich etwa gleichförmig gekrümmt und ohne Sättigungknick ist, der weichmagnetisch und damit für steigende und für fallende Feldstärke H weitgehend identisch ist, und dessen Steigung wenigstens im Verhältnis 1 : 100 variiert.

Die Widerstände R1 und R2 liegen beim Einschalten des Multivibrators, d.h. beim Anlegen der Eingangsspannung U so in Reihe mit den beiden Basis/Emitter-Strecken der beiden Transistoren Q1 und Q2, dass ein Strom fliesst. Hierdurch und unter Mitwirkung der Kondensatoren C3, C4 und der Dioden D1, D2 entsteht ein Ungleichgewicht, durch das einer der beiden Transistoren in den Sperr- und der andere in den Offen-Zustand gerät, was wiederum den Multivibrator als ganzes in den Schwing-Zustand bringt.

Der Einsatz des Bauelementes 10 in einem Multivibrator entsprechend Fig. 1 bringt vor allem eine wesentliche Verbesserung der Regeleigenschaften des Multivibrators wie Vergrösserung des Regelbereichs, Unempfindlichkeit gegen elektrische und mechanische Störungen, Robustheit, aber auch eine preisliche Verbesserung durch die Einfachheit des Aufbaus des Bauelements 10. Das Anschwingverhalten des Multivibrators ist sehr gut und erfolgt bereits bei einer Spannung U, die bei 1 bis wenige Volt liegt, was z.B. bei Batteriebetrieb sehr wichtig ist.

Als Variante kann die Induktionswicklung 15 des Bauelements 10 statt nur parallel geschaltet zu sein zu der Transformatorwicklung N2 und dem Basiswiderstand RB zusätzlich parallel geschaltet werden zur Primärwicklung N1 des Transformators T. In diesem Fall ergibt sich eine Kopplung des Verbindungspunktes der beiden Kondensatoren C1, C2 mit den Basen der Transistoren Q1, Q2 (mit entsprechend angepassten Dimensionierungen der gesamten Schaltung).

## Ansprüche

1. Astabiler, magnetisch gekoppelter Multivibrator mit zwei Leistungskondensatoren (C1, C2), die in Reihe an die Eingangsspannung (U) gelegt sind, und die durch zwei Schalttransistoren (Q1, Q2) und über eine Transformatorwicklung (N1) abwechselnd kurzschliessbar sind, und mit einer positiven Rückkopplung, die eine zweite Transformatorwicklung (N2), einen ohmschen Widerstand (RB) und einen diesen parallel geschalteten stromgesteuerten Induktor zur Frequenzeinstellung des Multivibrators umfasst, dadurch gekennzeichnet, dass der Induktor ein durch einen Steuerstrom (I) steuerbares Bauelement (10) mit variierbarer Induktivität (L) ist, das aufgebaut ist aus zwei voneinander unabhängigen, gleichen, koaxial angeordneten, ringförmig in sich geschlossenen, ferromagnetischen Kernen (11, 12), aus einer Steuerwicklung (17), die die beiden Kerne (11, 12) gemeinsam umwindet, und aus einer Induktionswicklung (15), die in Form zweier in Reihe geschalteter Teilwicklungen (15.1, 15.2) die beiden Kerne (11, 12) je einzeln umwindet, wobei der Wicklungssinn der Wicklungen (17, 15.1, 15.2) so gerichtet ist, dass die durch Ströme (I, i) durch die Wicklungen (17, 15.1, 15.2) in den Kernen (11, 12) erzeugten Magnetflüsse im einen der Kerne (z.B. 11) gleichgerichtet und im anderen der Kerne (z.B. 12) inversgerichtet sind, und wobei die funktionale Abhängigkeit der magnetischen Flussdichte (B) von der magnetischen Feldstärke (H) beim Kernmaterial einen Verlauf aufweist, der in seinem gesamten Bereich etwa gleichförmig gekrümmt und ohne Sättigungsknick ist, der weichmagnetisch und damit für steigende und für fallende Feldstärke (H) weitgehend identisch ist, und dessen Steigung wenigstens im Verhältnis 1 : 100 variiert.

2. Multivibrator nach Anspruch 1, dadurch gekennzeichnet, dass das Bauelement (10) mit seiner Induktionswicklung (15) parallel geschaltet ist zur Serienschaltung der zweiten Transformatorwicklung (N2) und des ohmschen Widerstandes (RB).

3. Multivibrator nach Anspruch 1, dadurch gekennzeichnet,
dass das Bauelement (10) mit seiner Induktionswicklung (15) parallel geschaltet ist zur Serienschaltung aus der ersten Transformatorwicklung (N1), aus der zweiten Transformatorwicklung (N2) und aus dem ohmschen Widerstand (RB).

4. Multivibrator nach Anspruch 1, 2 oder 3 dadurch gekennzeichnet, dass zum Zwecke des Anschwingens des Multivibrators
zwei ohmsche Widerstände (R1, R2) vorgesehen sind, die in Reihe mit den Emitter/Basis-Strecken der beiden Schalttransistoren (Q1, Q2) an die Eingangsspannung (U) geschaltet sind, und
dass zwei Kondensatoren (C3, C4) und zwei diesen parallel geschaltete Dioden (D1, D2) vorgesehen sind, die die Emitter der beiden Transistoren (Q1, Q2) miteinander verbinden.

## Claims

1. Astable, magnetically coupled multivibrator with two power capacitors (C1, C2), which are applied in series to the input voltage (U), and which can be alternately short-circuited by two switching transistors (Q1, Q2) and across a transformer winding (N1) and with a positive feedback, which comprises a second transformer winding (N2), an ohmic resistor (RB) and a current-controlled inductor connected in parallel thereto for the frequency setting of the multivibrator, characterized in that the inductor is a component (10) with a variable inductance (L) and which is controlled by a control current (I) and which is constructed from two independent, identical, coaxially arranged, annular-closed, ferromagnetic cores (11, 12), a control winding (17) jointly passing round the two cores (11, 12) and an induction coil (15), which in the form of two series-connected partial windings (15.1, 15.2) individually passes round each of the two cores (11, 12), the winding direction of the windings (17, 15.1, 15.2) being such that the magnetic fluxes produced in the cores (11, 12) by currents (I, i) through the windings (17, 15. 1, 15.2) are in the same direction in one of the cores (e.g. 11) and are reverse-directed in the other of the cores (e.g. 12) and in which the functional dependence of the magnetic flux density (B) on the magnetic field strength (H) in the core material has a configuration which is roughly uniformly curved in its entire area and has no saturation bend, which is soft magnetic and therefore substantially identical for rising and falling field strength (H) and whose pitch at least varies in the ratio 1 : 100.

2. Multivibrator according to claim 1, characterized in that the component (10) with its induction winding (15) is connected in parallel to the series connection of the second transformer winding (N2) and the ohmic resistor (RB).

3. Multivibrator according to claim 1, characterized in that the component (10) is connected in parallel with its induction winding (15) to the series connection of the first transformer winding (N1), the second transformer winding (N2) and the ohmic resistor (RB).

4. Multivibrator according to claims 1, 2 or 3, characterized in that for the purpose of the oscillation build-up of the multivibrator, two ohmic resistors (R1, R2) are provided, which are connected in series with the emitter-base sections of the two switching transistors (Q1, Q2) at the input voltage (U) and that two capacitors (C3, C4) and two diodes (D1, D2) connected in parallel thereto are provided, which interconnect the emitters of the two transistors (Q1, Q2).

## Revendications

1. Multivibrateur astable à couplage magnétique, avec deux condensateurs de puissance (CI, C2), qui sont mis en série sur la tension d'entrée (U), et qui sont susceptibles d'être court-circuités alternativement par deux transistors de commutation (Q1, Q2) et par l'intermédiaire d'un enroulement du transformateur (N1), et avec un rétro-couplage positif qui comprend un second enroulement de transformateur (N2), une résistance ohmique (RB) et un inducteur commandé par le courant et branché en parallèle sur cet enroulement et cette résistance pour permettre le réglage en fréquence du multivibrateur, multivibrateur caractérisé en ce que l'inducteur est un élément constitutif (10) à inductance variable (L) susceptible d'être commandé par un courant de commande (I), et qui est constitué par deux noyaux ferromagnétiques (11, 12) indépendant l'un de l'autre, identiques, disposés co-axialement et refermés sur eux-mêmes en forme d'anneaux, par un enroulement de commande (17) qui relie ensemble les deux noyaux (11, 12), et par un enroulement d'induction (15) qui, sous la forme de deux enroulements partiels branchés en série (15.1, 15.2) entourent individuellement chacun des deux noyaux (11, 12) le sens de bobinage des enroulements (17, 15.1, 15.2) étant tel que les flux magnétiques engendrés dans les noyaux (11, 12) par les courants (I, i) traversant les enroulements (17, 15.1, 15.2) sont orientés selon un certain sens dans un des noyaux (par exemple 11) et selon le sens inverse dans l'autre noyau (par exemple 12), tandis que la dépendance fonctionnelle entre la densité (B) du flux magnétique et l'intensité (H) du champ magnétique dans le matériau du noyau, présente une évolution qui est à peu près courbée uniformément dans son ensemble et sans présenter de coude de saturation, qui est faiblement magnétique et donc identique dans une large mesure pour des intensités de champ (H) croissantes et pour des intensités de champ décroissantes, tandis que sa pente varie au moins dans le rapport 1 : 100.

2. Multivibrateur selon la revendication 1, caractérisé en ce que l'enroulement d'induction (15) de l'élément constitutif (10) est branché en parallèle par rapport au branchement en série du second enroulement de transformateur (N2) et de la résistance ohmique (RB).

3. Multivibrateur selon la revendication 1, caractérisé en ce que l'enroulement d'induction (15) de l'élément constitutif (10) est branché en parallèle par rapport au branchement en série constitué du premier enroulement de transformateur (N1), du second enroulement de transformateur (N2) et de la résistance ohmique (RB).

4. Multivibrateur selon la revendication 1, la revendication 2 ou la revendication 3, caractérisé en ce qu'il est prévu pour l'amorçage des oscillations du multivibrateur, deux résistances ohmiques (R1, R2) qui sont branchées en série avec la section émetteur-/base des deux transistors de commutation (Q1, Q2) sur la tension d'entrée (U), et qu'il est prévu deux condensateurs (C3, C4) et, branchées en parallèle sur ceux-ci, deux diodes (D1, D2) qui relient ensemble les émetteurs des deux transistors (Q1, Q2).

Fig. 1

Fig. 2

Fig. 3